Europäisches Patentamt

European Patent Office

Office européen des brevets

(19)

(11) EP 0 762 646 A1

(12) EUROPEAN PATENT APPLICATION

(43) Date of publication:
12.03.1997 Bulletin 1997/11

(51) Int Cl.⁶: H03H 15/00

(21) Application number: 96305299.8

(22) Date of filing: 19.07.1996

(84) Designated Contracting States:
DE FR GB IT

(30) Priority: 22.08.1995 US 518096

(71) Applicant: HEWLETT-PACKARD COMPANY
Palo Alto, California 94304-1181 (US)

(72) Inventor: Setterberg, Brian D.
McMinnville, OR 97218 (US)

(74) Representative: Colgan, Stephen James et al
CARPMAELS & RANSFORD
43 Bloomsbury Square
London WC1A 2RA (GB)

(54) **Continuous-time finite impulse response filter for analog signal processing**

(57) An analog filter 20 accepts a continuously variable incoming signal $a(t)$ and produces a continuously variable filtered signal $b(t)$. The filter includes a plurality of continuous-time signal delay elements 22 connected in series with each other. A first of the delay elements receives the incoming signal. The delay elements thus produce a plurality of continuously variable signals which are delayed by increasing delay periods relative to the incoming signal. A plurality of continuous-time signal amplifiers 24 are connected to receive respective delayed signals from the delay elements and to produce a plurality of amplified continuous-time signals in response. The amplified signals are summed at a continuous-time summing circuit 34, resulting in the filtered analog signal. The gains of the respective amplifiers can be individually, digitally, and dynamically programmed, so that a microprocessor or other similar device can independently establish both the magnitude response and the phase response of the filtered signal relative to the incoming signal.

Fig 1

Description

## TECHNICAL FIELD

This invention relates to electronic circuits and filters, and more particularly to analog or continuous-time filters having magnitude and phase responses which can be independently and arbitrarily specified.

## BACKGROUND OF THE INVENTION

Digital signal processing techniques are becoming increasingly popular for implementing signal filters. Digital signal processing (DSP) has many advantages over traditional analog filtering, such as repeatability, the ability to construct filters with arbitrary magnitude and phase response, and the ability to control and dynamically change filter parameters from microprocessor-based systems. A finite impulse response (FIR) filter is a particularly useful filter which can be implemented with DSP.

The characteristics of digital FIR filters are well known and documented. Oppenheim, Alan V., and Schafer, Ronald W., *Digital Signal Processing,* pp. 237-268, Prentice-Hall, Inc., Englewood Cliffs, New Jersey, 1975, and Loy, Nicholas J., *An Engineers Guide to FIR Digital Filters,* Prentice Hall, Englewood Cliffs, New Jersey, 1988, are examples of references describing digital FIRs and methods of calculating appropriate coefficient values to obtain desired filter characteristics.

While DSP has many advantages, it also has disadvantages. One disadvantage of DSP is that it requires complex circuitry for sampling and signal synthesis. Another disadvantage is that DSP usually requires significant microprocessor computing bandwidth. Furthermore, significant engineering effort, including both hardware and software design, is often required when implementing a DSP system. Such factors tend to increase the expenses of designing and manufacturing DSP systems, and to make such systems relatively larger and less power-efficient than comparable analog systems.

Additionally, there are certain situations in which the design of a DSP system is particularly difficult. One such case is where a signal contains a broad range of desired frequencies. In this case, a DSP system must use a high sampling rate to avoid aliasing. However, a high sampling rate makes it very difficult to effectively filter low-frequency components of the signal. Although there are techniques for dealing with this problem, such techniques again add significant expense and complexity to the resulting system.

One application for the invention described below is as a high-pass filter in an electro-cardiograph (ECG) monitoring system. Severe low-frequency constraints are placed on the analog electronics in ECG monitoring systems. Significant signal energy is present in the ECG signal at frequencies as low as 0.5 Hz. To avoid phase distortion at these low frequencies, traditional ECG front end amplifiers have low frequency high-pass poles at 0.05 Hz (a full decade below the required 0.5 Hz). This is done to avoid the effects of phase distortion of the signal frequencies of interest. The phase distortion that would be caused by placing the high-pass poles of such a filter at 0.5 Hz has been shown to cause errors that can result in clinical misinterpretation of ECGs. Setting the high-pass pole a decade lower than the lowest frequency of interest avoids significant phase distortion, but also allows very low frequency energy to corrupt the signal, making interpretation of the ECG difficult. In addition, the 0.05 Hz time constants are so slow that amplifier offset recovery time can be more than 15 seconds unless special recovery circuits are utilized.

DSP techniques can be particularly burdensome in this environment. Frequencies of interest in the ECG signal vary over a wide range, from 0.5 Hz to over 200 Hz., requiring complex DSP techniques. Furthermore, ECG monitoring is required in small, battery-operated devices which are carried with a person. It would be very desirable to avoid the cost and complexity of DSP circuits in such devices, while still maintaining the design flexibility of DSP techniques.

## SUMMARY OF THE INVENTION

The invention solves many of the problems associated with prior art DSP techniques while retaining significant advantages of such techniques. The invention includes an analog circuit which can be analyzed in terms of a digital FIR circuit, using digital DSP analysis and design techniques. Unlike the digital FIR circuit, however, this analog circuit, referred to herein as an analog FIR filter, accepts a continuously variable incoming signal and produces a continuously variable filtered output signal. The analog filter includes a plurality of continuous-time signal delay elements connected in series with each other to produce a plurality of continuously variable signals which are delayed relative to the incoming signal. The delayed signals are multiplied by filter coefficients at analog amplifiers. The multiplied signals are then summed, resulting in the filtered signal. The gains of the amplifiers, which can be digitally established and dynamically changed, are set to independently establish both the magnitude response and the phase response of the filtered signal relative to the incoming signal.

**BRIEF DESCRIPTION OF THE DRAWINGS**

Fig. 1 is a functional block diagram of a prior art digital FIR filter.

Fig. 2 is a block diagram of a typical implementation of the prior art digital FIR filter of Fig. 1.

Fig. 3 is a block diagram of an analog, continuous-time filter in accordance with a preferred embodiment of this invention.

Fig. 4 is a simplified schematic of an exemplary amplifier circuit.

Fig. 5 is a block diagram of cascaded analog continuous-time filters in accordance with a preferred embodiment of the invention.

**DETAILED DESCRIPTION OF THE PREFERRED EMBODIMENT**

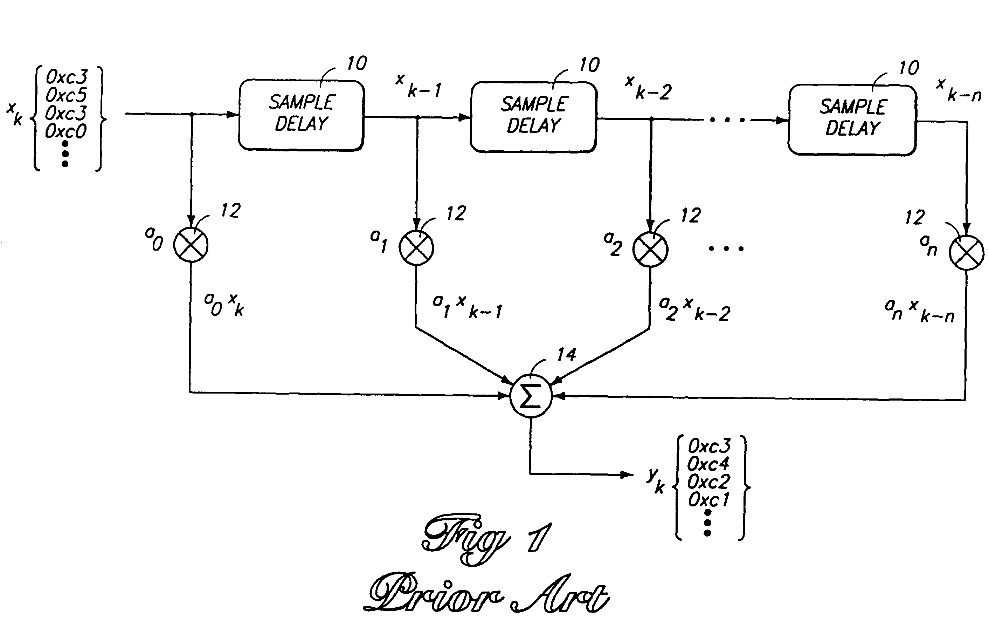

A functional diagram of a prior art FIR filter is shown in Fig. 1. It comprises a series of digital delay elements 10 which are connected in series. The first or left-most delay element receives a periodic sequence of discretely sampled signal values in digital form. Each delay element holds each signal value for a predetermined number of sample periods and then produces it for the next delay element in the series. In the example shown, the original, unfiltered signal is represented by a sequence of digital values $x$. The nomenclature $x_k$ indicates the value of $x$ at a discrete sample time $k$ (an examplary partial sequence is shown in Fig. 1, in the brackets to the right of variable $x_k$). $x_{k-1}$ indicates the value of $x$ at the discrete sample time preceding $k$. Fig. 1 assumes that each delay element has a delay period of one sample period. Accordingly, at any given time the first delay element 10 accepts $x_k$ and outputs $x_{k-1}$; the next delay element accepts $x_{k-1}$ and outputs $x_{k-2}$; and so forth. The $x$ values available at any given time represent the current or most recent sample value $x_k$ and the delayed sample values $x_{k-1}$ through $x_{k-n}$. These sample values are fed to respective digital coefficient multipliers 12. The coefficient multipliers multiply the individual sample values by respective coefficients $a_0$ through $a_n$, resulting in the terms $a_0 x_k$ through $a_n x_{k-n}$. A digital summing junction 14 accepts these terms to produce a filtered signal value $y_k$ (example values shown in brackets). Over time, the filter produces a sequence of filtered signal values $y$, corresponding respectively to the sequence of unfiltered signal values $x$. The value of $y$ at a given discrete time $k$ is given by the equation

$$y_k = \sum_{i=0}^{n} a_i x_{k-i} \, ,$$

where $n$ is the total number of delay elements and multipliers.

Coefficients $a_0$ through $a_n$ allow both the magnitude response and the phase response of the filter to be arbitrarily specified, independently of each other. This is in contrast to traditional analog filters in which only the magnitude response or only the phase response can be uniquely specified. It is a great advantage to be able to determine the magnitude response and the phase response independently of each other.

While the block diagram of Fig. 1 appears simple, its actual implementation is much more complex. For example, Fig. 1 ignores the fact that real world signals do not naturally exist as a series of digital values. Likewise, an electronic filter usually needs to provide an analog output rather than a digital output. Accordingly, analog-to-digital and subsequent digital-to-analog conversion must be performed in addition to the functions shown in Fig. 1. Other complexities arise because of the requirements of supporting and programming a digital signal processor.

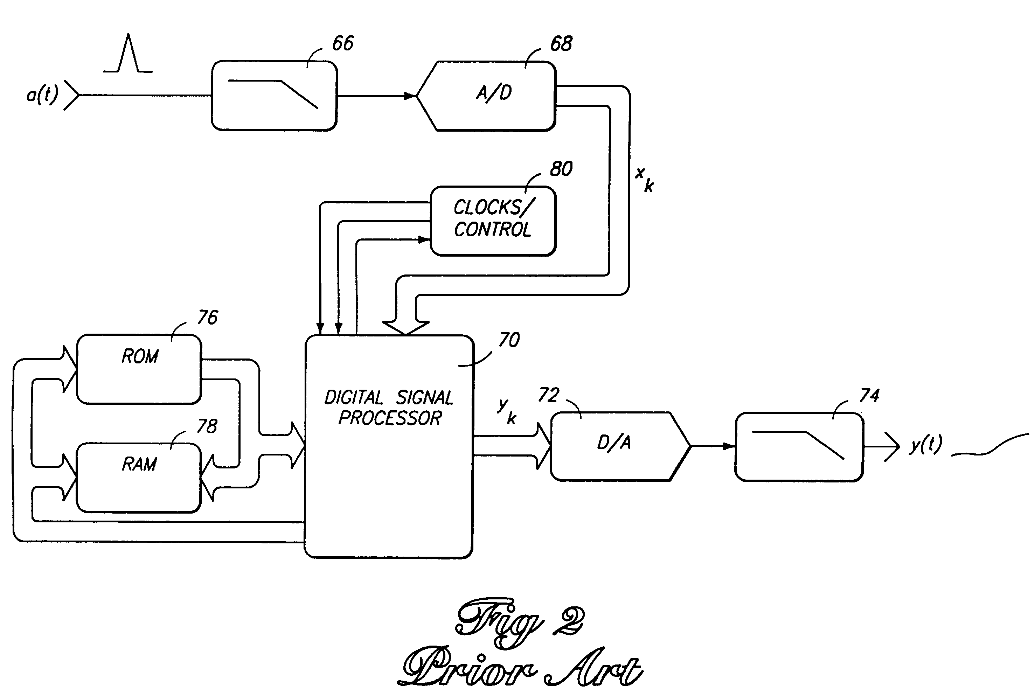

Fig. 2 is a block diagram showing a typical digital processing circuit used to implement a digital FIR filter such as that of Fig. 1. The circuit includes an analog anti-alias low-pass filter 66 and an A/D converter 68 which accept an analog input single $a(t)$ (where the variable $t$ represents time) and which, in response, produce a time-sampled digital input signal $x_k$. Digital input signal $x_k$ comprises a sequence of discrete digital values representing the sampled magnitude of analog input single $a(t)$ at discrete intervals. Digital input signal $x_k$ is accepted by a digital signal processor 70. Signal processor 70 is programmed to implement the functions illustrated by Fig. 1, and to produce $y_k$, a sequence of filtered digital values. These values are fed to a digital-to-analog converter 72 and then to an analog reconstruction filter 74 to produce an analog output signal $y(t)$.

While the use of a digital signal processor results in a great deal of flexibility, it also requires complex and expensive support circuitry such as, for example, read-only memory (ROM) 76, read/write random access memory (RAM) 78, and accurate clock and control circuitry 80 to synchronize signal sampling and processing. Other components, not shown, are also often required to support a digital signal processing circuit. Furthermore, programming a digital signal processor to implement the functions of Fig. 1 is a complex and time-consuming task.

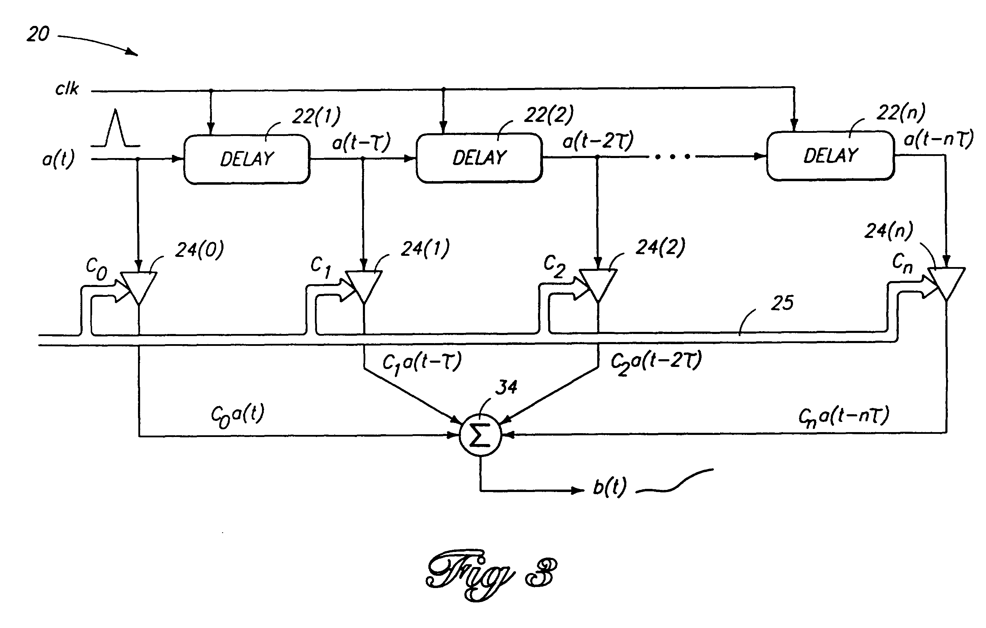

Fig. 3 shows an analog, continuous-time filter in accordance with a preferred embodiment of the invention, generally referenced by the numeral 20. Filter 20 has an analog signal input that accepts an analog, continuously variable incoming signal $a(t)$. Filter 20 has an analog signal output that produces an analog, continuously variable output or filtered signal $b(t)$ (where the variable $t$ represents time). Filter 20 further includes a continuous-time electronic filter circuit operably connected between the analog signal input and the analog signal output. In contrast to the digital elements of Figs. 1 and 2, this circuit utilizes analog elements which operate in continuous time such as conventional analog delay elements and amplifiers. However, the circuit is tunable to arbitrarily and independently establish both the magnitude response and the phase response of the filtered signal relative to the incoming signal.

Filter 20 thus accepts an analog input, and does not require analog-to-digital conversion. Likewise, filter 20 produces an analog output without digital-to-analog conversion. The complexities associated with digital signal processors are not present in the circuit of Fig. 3, and no programming is required. Nonetheless, the characteristics of filter 20 can be set and changed with a microprocessor through digital control registers if desired, even though microprocessor support is not needed for actual operation of the filter. Filter 20 thus avoids the complexities and expenses of prior art digital signal processing while maintaining its flexibility.

Filter 20 comprises a plurality of analog, continuous-time signal delay elements 22(1) through 22(n). In the exemplary embodiment described herein, these elements comprise MN3010 Bucket Brigades, available from Panasonic Industrial Company of Secaucus, New Jersey. These devices are dual 512-stage analog shift registers which are clocked by an external clocking signal $clk$. Thus, each delay element 22 produces a delay period $\tau$ of 512 clocking signals. The delay period can be varied by changing the frequency of clocking signal $clk$. Although analog shift registers are sampling devices, they are conventionally analyzed as continuous-time elements. They can be considered continuous-time elements for purposes of filter 20 because their sampling frequency is much greater than frequencies within the useful range of filter 20. For example, the sampling frequency of the Panasonic analog shift register mentioned above ranges from 10 kHz to 100 kHz. The sampling frequency of the analog shift register is preferably set at least an order of magnitude greater than the highest frequency of interest in filter 20.

Analog signal delay elements 22 are connected in series with each other so that the output of a preceding element is received at the input of a succeeding element. The first or left-most delay element 22(1) in Fig. 3 receives incoming signal $a(t)$. The series-connected delay elements 22 produce a plurality of continuously variable signals which are delayed by increasing delay periods relative to the incoming signal $a(t)$. For instance, first delay element 22(1) produces a delayed signal $a(t-\tau)$; second delay element 22(2) produces a delayed signal $a(t-2\tau)$; and $n^{th}$ delay element 22($n$) produces a delayed signal $a(t-n\tau)$.

Filter 20 further comprises a plurality of analog, continuous-time signal multipliers or variable-gain amplifiers 24 (0) through 24(n), respectively having signal inputs connected to receive a corresponding one of the incoming signal $a(t)$ and the delayed signals $a(t-\tau)$ through $a(t-n\tau)$. Amplifiers 24 have independently variable linear gains or coefficients $C_0$ through $C_n$, and produce a plurality of amplified signals $C_0 a(t)$ through $C_n a(1-n\tau)$. The coefficients are provided by a digital control bus 25, also referred to herein as a digital adjustment input. Digital control bus 25 allows an external device such as a microprocessor to dynamically tune the filter. Alternatively, coefficients $C_0$ through $C_n$ can be provided by manual means such as thumbwheel switches.

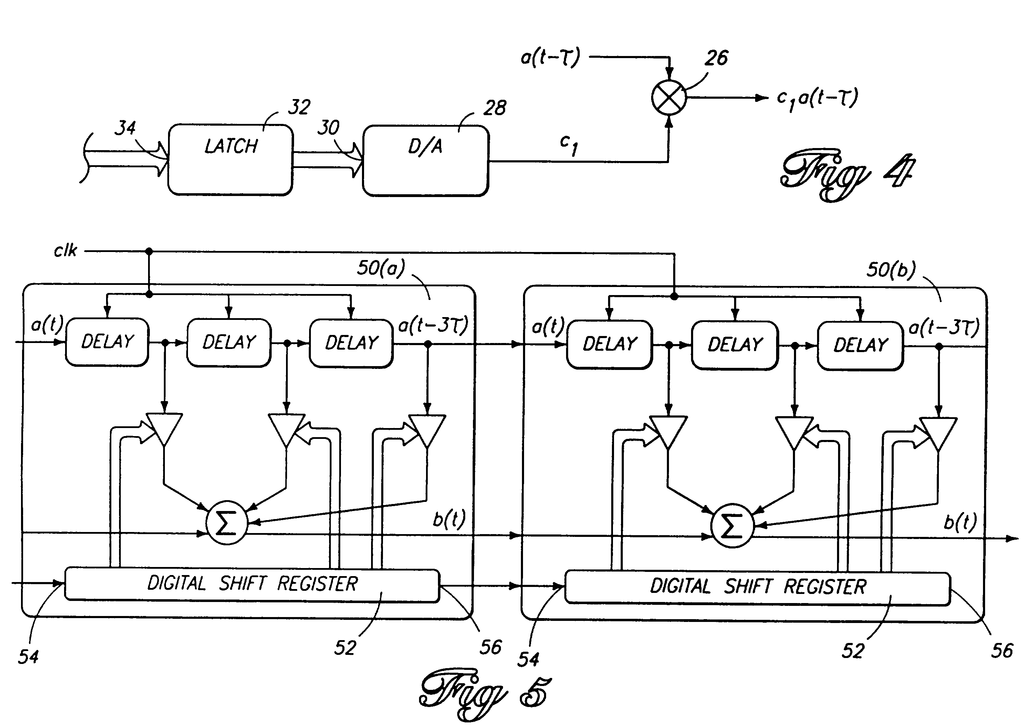

As an example, Fig. 4 shows one amplifier 24(1) in more detail. Amplifier 24(1) comprises an analog multiplier cell 26 which receives and is responsive to delayed signal $a(t-\tau)$ and a coefficient signal $c_1$. Multiplier cell 26 in the preferred embodiment is an AD633 Analog Multiplier such as available from Analog Devices of Norwood, Massachusetts. Coefficient signal $c_1$ is generated by a digital-to-analog (D/A) converter 28 having digital D/A inputs 30. A digital latch or storage register 32 has digital register inputs 34. Storage register 32 is connected so that the digital value stored therein is presented continuously at D/A inputs 30. D/A converter 28 is thus responsive to register inputs 34 to vary coefficient signal $c_1$ and to produce amplified signal $c_1 a(t-\tau)$ based on delayed signal $a(t-\tau)$.

Referring again to Fig. 3, filter 20 also comprises a continuous-time summing circuit or junction 34 which receives and sums the plurality of amplified signals $C_0 a(t)$ through $C_n a(t-n\tau)$. Summing circuit 34 produces $b(t)$, equal to

$$\sum\nolimits_{i=0}^{n} C_i a(t - i\tau),$$

where $n$ is the number of delay elements.

The circuit described above is not a digital filter, and does not operate on sampled data. Rather, the input and output of the circuit are continuously varying analog signals and the circuit performs analog or continuous-time operations on these signals. However, the particular configuration of amplifiers 24 allows their gains to be individually, dynamically, and digitally programmed from a source such as a microprocessor. Specifically, the gains $C$ of the individual amplifiers can be digitally and dynamically specified to independently establish both the magnitude response and the phase response of the filtered signal relative to the incoming signal.

The characteristics of the analog filter of Fig. 3 have been successfully analyzed using techniques previously used for digital FIR filters. Accordingly, given a desired magnitude response and a desired phase response, coefficients $c_0$ through $c_n$ can be derived using digital filter design techniques such as disclosed in the references cited above. Computer-aided design tools are also available for assisting in such derivations. For example, the software product "Pro-Matlab" is available from The Math Works, Inc., of Natick, Massachusetts, for analyzing and designing digital filters including digital FIR filters.

Note, however, that the ideal coefficients derived using these techniques are corrected to compensate for non-ideal responses of the various circuit elements of filter 20. For example, an ideal amplifier would have a gain of 1.0 if given a coefficient of 1.0. Due to the practicalities of building real amplifiers and delay elements, however, gain errors may be present. Such errors could have a negative impact on filter performance. To minimize or eliminate any such negative impact, the amplifiers are characterized and coefficients are normalized based on the characterization. Specifically, a correction factor $e$ corresponding to each of coefficients $c_0$ through $c_n$ is determined by measurement. For example, the correction factors can be calculated by feeding an impulse signal through the filter and measuring the magnitudes of the resulting series of impulses from summing circuit 34. Calculation of coefficients $c_0$ through $c_n$ is as follows, where $a_0$ through $a_n$ represent the "ideal" coefficients for each amplifier, derived using common FIR filter design techniques:

$$\begin{bmatrix} c_0 \\ c_1 \\ c_2 \\ \cdot \\ \cdot \\ c_n \end{bmatrix} = \begin{bmatrix} a_0 & 0 & 0 & \ldots & 0 \\ 0 & a_1 & 0 & \ldots & 0 \\ 0 & 0 & a_2 & \ldots & 0 \\ \cdot & \cdot & \cdot & \ldots & \cdot \\ \cdot & \cdot & \cdot & \ldots & \cdot \\ 0 & 0 & 0 & \ldots & a_n \end{bmatrix} \begin{bmatrix} e_0 \\ e_1 \\ e_2 \\ \cdot \\ \cdot \\ e_n \end{bmatrix}$$

The performance of an analog filter as described above is very close to the performance of an ideal digital FIR filter.

Further advantages can be obtained by providing variability in delay period $\tau$. Varying $\tau$ has the effect of shifting the magnitude and phase response of filtered signal $b(t)$ with respect to frequency. For instance, if a certain response is obtained over a frequency range of 100 Hz to 200 Hz, the same response can be shifted to occur over the frequency range of 200 Hz to 400 Hz by doubling the frequency of clocking signal $clk$. It is thus useful to view signal $clk$ as a common delay control signal--the frequency of signal $clk$ is variable to shift the magnitude and phase response of the filtered signal $b(t)$ with respect to frequency. Although not shown in Fig. 3, signal $clk$ can be controlled by a digital delay control input or other means so that its frequency can be dynamically set and varied by a microprocessor. Other implementations of filter 20 might have alternative means for varying delay period $\tau$.

The analog filter described above presents a number of very useful advantages. Some of these advantages are similar to those obtained with digital FIR filters. For example, the analog filter allows arbitrarily specified magnitude and phase responses--conventional analog filters only permit one of these parameters to be uniquely specified. As with a digital FIR filter, the analog filter can be constructed to have an exactly linear phase response by choosing symmetrical coefficients. Additionally, the frequency response of the analog filter can be easily modified by simply changing filter coefficients. Since the coefficients are stored digitally in registers, they can be adjusted by a system controller such as an instrument panel switch or a microprocessor. Also, with a given set of coefficients the resulting frequency response of an analog filter in accordance with the invention can be shifted up or down in frequency by changing the delay period in the delay elements.

In addition to the advantages in common with digital FIR filters, the analog filter of this invention has further advantages which are not exhibited by digital FIR filters. For instance, problems such as aliasing that arise from signal sampling are not a concern with the analog filter of this invention. Furthermore, the filter of this invention is well suited to low frequency signal processing. Thus, the analog filter can serve as an ideal adjunct to digital signal processing systems in environments that span wide bandwidths. Traditionally, wide-bandwidth systems that use only digital signal processors have had to resort to complex techniques such as multi-rate digital signal processing in order to effectively filter at low frequencies. By adding analog filters such as described herein to the signal path, these computationally intensive digital signal processing algorithms can be avoided.

As a specific example, an analog filter such as described above can be implemented as a high-pass filter for the ECG monitoring system mentioned above in the "Background of the Invention" section. By using the analog filter, it is possible to place the high-pass pole at 0.5 Hz, while still avoiding phase distortion above 0.5 Hz. Another important advantage, particularly in this application, is that the analog circuits can be implemented in a very compact and power-efficient form, without complex digital processing or other support components.

The analog filter of this invention can be implemented in a single-chip integrated circuit package, designed modularly so that multiple circuits can be cascaded to provide arbitrary numbers of coefficients. Fig. 5 shows an example of two cascaded integrated circuits 50(a) and 50(b). Each circuit 50 is a single filter having three filter coefficients. An arbitrary number of such filter circuits can be cascaded to provide different numbers of filter coefficients. As shown, the filtered signal $b(t)$ of a preceding filter circuit 50(a) is received by the summing circuit of a succeeding filter circuit 50(b) and summed with the plurality of amplified signals $c_0 a(t)$ through $c_n a(t\text{-}n\tau)$ at that circuit. The delayed signal from the last delay element within each filter circuit, $a(t\text{-}n\tau)$, forms the incoming signal $a(t)$ of the succeeding filter circuit.

Coefficients can be provided in a variety of ways, such as through a parallel data bus with appropriate address decoding. In the embodiment of Fig. 5, however, each filter circuit 50 has a digital shift register 52 with three registers. Digital shift register 52 has a digital input 54 and a digital output 56. Parallel coefficient data bits are shifted serially in and through each filter circuit to the succeeding circuit. In the circuit shown, six values are clocked into the first filter circuit 50(a)--one for each of the six stages of the composite filter. The first three of these are shifted through to the second filter circuit 50(b).

The circuits described above embody operational steps which are also encompassed by the invention. Such steps include successively delaying the incoming signal in continuous time to produce a plurality of continuously variable signals which are delayed by increasing delay periods relative to the incoming signal. The steps of the invention further include amplifying the delayed signals in continuous time by respective gains to produce a plurality of amplified signals based on the delayed signals, and summing the amplified signals in continuous time to produce the filtered signal. The invention includes specifying the respective amplifier gains to establish both the magnitude and the phase response of the filtered signal relative to the incoming signal. In the preferred embodiment, this includes supplying digital codes, coefficients, or gain values, and converting said digital codes, coefficients, or gain values to analog signals for use in conjunction with analog multipliers. The preferred methods of the invention further include dynamically changing or programming the respective gains and the duration of the increasing delay periods. The specific elements noted above form the means for performing these functions.

In compliance with the statute, the invention has been described in language more or less specific as to structural and methodological features. It is to be understood, however, that the invention is not limited to the specific features described, since the means herein disclosed comprise preferred forms of putting the invention into effect. The invention is, therefore, claimed in any of its forms or modifications within the proper scope of the appended claims appropriately interpreted in accordance with the doctrine of equivalents.

## Claims

1. An analog filter (20) which accepts a continuously variable incoming signal and produces a continuously variable filtered signal having a magnitude and phase response in relation to the incoming signal, the analog filter comprising:

   a plurality of continuous-time signal delay elements (22) connected to produce a plurality of continuously variable signals which are delayed by increasing delay periods relative to the incoming signal;
   a plurality of continuous-time signal amplifiers (24) respectively having signal inputs connected to receive corresponding delayed signals from the delay elements, the continuous-time signal amplifiers having individual gains to produce a plurality of amplified signals based on the delayed signals;
   a continuous-time summing circuit (34) which receives and sums the plurality of amplified signals to produce the filtered signal;
   wherein the gains of the individual signal amplifiers are specified to independently establish both the magnitude response and the phase response of the filtered signal relative to the incoming signal.

2. An analog filter as recited in claim 1 wherein the gains of the continuous-time signal amplifiers are individually, dynamically, and digitally programmable.

3. An analog filter as recited in claim 1 wherein the delay periods of the signal delay elements are variable.

4. An analog filter as recited in claim 1 wherein the delay periods of the signal delay elements are determined by a common delay control signal to shift the magnitude and phase response of the filtered signal with respect to frequency.

5. A plurality of the analog filters recited in claim 1, said analog filters being cascaded wherein:

   the filtered signal of a preceding analog filter is received by the summing circuit of a succeeding analog filter and summed with the plurality of amplified signals at the succeeding analog filter;
one of the delayed signals from said preceding analog filter forms the incoming signal of said succeeding analog filter.

6. A method of filtering a continuously variable incoming signal to produce a continuously variable filtered signal having a magnitude and phase response in relation to the incoming signal, comprising:

successively delaying the incoming signal in continuous time to produce a plurality of continuously variable signals which are delayed by increasing delay periods relative to the incoming signal;
amplifying the delayed signals in continuous time by respective gains to produce a plurality of amplified signals based on the delayed signals;
summing the amplified signals in continuous time to produce the filtered signal;
specifying said respective gains to independently establish both the magnitude response and the phase response of the filtered signal relative to the incoming signal.

7. A method as recited in claim 6 wherein said step of specifying said respective gains comprises converting a digital coefficient value to an analog signal.

8. A method as recited in claim 6 and further comprising dynamically programming the respective gains to dynamically change the magnitude and phase response of the filtered signal relative to the incoming signal.

9. A method as recited in claim 6 and further comprising changing the increasing delay periods to shift the magnitude and phase response of the filtered signal with respect to frequency.

10. A method as recited in claim 6 and further comprising:

measuring error coefficients corresponding respectively to the amplified signals; and
correcting the respective gains based upon the measured error coefficients.

Fig. 1
Prior Art

Fig. 2
Prior Art

Fig. 3

Fig. 4

Fig. 5

| | European Patent Office | **EUROPEAN SEARCH REPORT** | Application Number EP 96 30 5299 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | FR-A-1 383 174 (IBM) 16 November 1964 * the whole document * | 1-4,6 | H03H15/00 |
| A | | 8,9 | |
| | --- | | |
| Y | US-A-4 218 752 (HEWES CHARLES R ET AL) 19 August 1980 * column 3, line 59 - column 4, line 45; figures 1,2 * * column 1, line 42 - column 1, line 50 * | 1-4,6 | |
| | --- | | |
| A | IEEE TRANSACTIONS ON AEROSPACE AND ELECTRONIC SYSTEMS, vol. 16, no. 2, March 1980, NEW YORK US, page 238244 XP002019826 R.J.EVANS ET AL: "IMPROVED RANGE RESOLUTION FILTERS FOR RECTANGULAR-PULSE RADAR SYSTEMS" * page 241, column 1, line 1 - page 241, column 2, line 37; figures 4D,,4F * | 5 | |
| | --- | | |
| A | US-A-4 539 536 (WHITE STANLEY A) 3 September 1985 * column 1, line 53 - column 1, line 64 * * column 3, line 30 - column 3, line 55 * | 1,2,6-8, 10 | TECHNICAL FIELDS SEARCHED (Int.Cl.6) H03H |
| | ----- | | |

The present search report has been drawn up for all claims

| Place of search | Date of completion of the search | Examiner |
|---|---|---|
| THE HAGUE | 29 November 1996 | Coppieters, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)